(19) Europäisches Patentamt
European Patent Office
Office européen des brevets

(11) **EP 3 676 960 B1**

(12) **FASCICULE DE BREVET EUROPEEN**

(45) Date de publication et mention de la délivrance du brevet:
**13.10.2021 Bulletin 2021/41**

(21) Numéro de dépôt: **17768183.0**

(22) Date de dépôt: **29.08.2017**

(51) Int Cl.:
*H03K 17/78* *(2006.01)*     *G01R 13/34* *(2006.01)*
*H01L 31/08* *(2006.01)*

(86) Numéro de dépôt international:
**PCT/FR2017/052295**

(87) Numéro de publication internationale:
**WO 2019/043301 (07.03.2019 Gazette 2019/10)**

(54) **COMMUTATEUR OPTIQUE INTÉGRÉ**

INTEGRIERTER OPTISCHER SCHALTER

INTEGRATED OPTICAL SWITCH

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(43) Date de publication de la demande:
**08.07.2020 Bulletin 2020/28**

(73) Titulaire: **STMicroelectronics S.A.**
**92120 Montrouge (FR)**

(72) Inventeurs:
- **ZEGMOUT, Hanae**
  **38660 Saint Vincent De Mercuze (FR)**
- **PACHE, Denis**
  **38100 Grenoble (FR)**
- **LE TUAL, Stéphane**
  **38120 St-Egreve (FR)**
- **ROUX, Jean-François**
  **73000 Chambery (FR)**
- **COUTAZ, Jean-Louis**
  **73160 Saint Cassin (FR)**

(74) Mandataire: **Casalonga**
**Casalonga & Partners**
**Bayerstraße 71/73**
**80335 München (DE)**

(56) Documents cités:
**US-A1- 2001 055 327     US-A1- 2015 349 182**

- **TRIPON-CANSELIET C ET AL: "High dynamic range single channel sampling of wideband RF signals using ultra-fast nanoscale photoconductive switching", ELECTRONICS LET, IEE STEVENAGE, GB, vol. 52, no. 3, 4 février 2016 (2016-02-04), pages 237-239, XP006055186, ISSN: 0013-5194, DOI: 10.1049/EL.2015.2418**
- **KUPPAM MOHAN BABU ET AL: "Study of Ultrafast Semiconductor Photoswitches for CW RF Signal Sampling and Modulation", JOURNAL OF LIGHTWAVE TECHNOLOGY, IEEE SERVICE CENTER, NEW YORK, NY, US, vol. 32, no. 20, 15 octobre 2014 (2014-10-15), pages 3839-3845, XP011558123, ISSN: 0733-8724, DOI: 10.1109/JLT.2014.2334063 [extrait le 2014-09-04]**
- **GUI HUAIMENG ET AL: "The Jitter Time of GaAs Photoconductive Switch Triggered by 532- and 1064-nm Laser Pulse", IEEE PHOTONICS TECHNOLOGY LETTERS, IEEE SERVICE CENTER, PISCATAWAY, NJ, US, vol. 27, no. 19, 1 octobre 2015 (2015-10-01), pages 2001-2003, XP011667592, ISSN: 1041-1135, DOI: 10.1109/LPT.2015.2444914 [extrait le 2015-08-28]**

**Description**

Des modes de réalisation de l'invention concernent les dispositifs de commutation, par exemple mais non exclusivement ceux utilisés dans les dispositifs de conversion analogique-numérique, en particulier dans les échantillonneurs-bloqueurs.

Un échantillonneur-bloqueur est un dispositif qui échantillonne un signal analogique et qui, de façon périodique, maintient la valeur du signal analogique à un niveau constant pendant une période déterminée.

A cette fin, les échantillonneurs-bloqueurs peuvent par exemple comporter un commutateur commandé par un signal impulsionnel périodique et couplé à un élément capacitif, et sont configurés pour recevoir en entrée le signal analogique à échantillonner, et pour délivrer en sortie le signal échantillonné.

Classiquement, les signaux impulsionnels périodiques sont générés par des générateurs de signaux d'horloge électroniques.

Dans ce type de signaux, il est courant d'observer un phénomène de gigue (« jitter » en langue anglaise), qui correspond à des décalages temporels entre les impulsions du signal généré et les impulsions théoriques que l'on devrait observer au vu de la fréquence théorique du générateur de signal d'horloge. La gigue peut être notamment causée par des interférences électromagnétiques et peut entraîner des erreurs de transmission de données.

Il est par exemple possible d'observer des variations de l'ordre de 50 femto-secondes entre certaines impulsions d'un signal généré et un signal théorique de même fréquence.

Une solution à ce problème comprend l'utilisation d'un signal optique impulsionnel, émis par exemple par un laser, transmis à un corps photoconducteur dont la variation de la résistivité est cadencée par le signal optique. Cela peut permettre, en fonction du laser utilisé, de diviser par cinq le phénomène de gigue. Un tel commutateur est connu du document US 2015 349182

Cependant, ce type de commutateur possède un mauvais rapport de la résistivité du photoconducteur à l'état bloqué sur la résistivité du photoconducteur à l'état passant, ce qui entraîne une perte d'efficacité du commutateur.

Ainsi, selon un mode de réalisation, il est proposé un commutateur pouvant par exemple être utilisé dans des échantillonneurs-bloqueurs, présentant des effets de gigue limités et qui a un rapport de sa résistivité à l'état bloqué sur sa résistivité à l'état passant, élevé.

Selon un aspect, il est proposé un commutateur optique intégré réalisé dans et sur un substrat semi-conducteur, comportant un corps photoconducteur comprenant une première extrémité configurée pour recevoir un signal électrique d'entrée et une deuxième extrémité configurée pour délivrer un signal électrique de sortie, le corps photoconducteur ayant un état électriquement passant activé par la présence d'un signal optique et un état électriquement bloqué activé par l'absence du signal optique, dans lequel la direction allant de la première extrémité vers la deuxième extrémité définit une direction longitudinal.

Le corps photoconducteur a une section transversale orthogonale à la direction longitudinale diminuant progressivement selon la direction longitudinale depuis la première extrémité vers la deuxième extrémité.

Les inventeurs ont observé que la baisse de la résistivité du corps photoconducteur dépend notamment du nombre de photons absorbés. Et, le nombre de photons absorbés étant décroissant le long du corps photoconducteur, un corps photoconducteur de section constante éclairé par un signal optique présente une résistivité qui n'est pas homogène, et plus précisément qui croît entre la première et la deuxième extrémité.

Ainsi, réduire progressivement la section du corps photoconducteur permet de compenser cette croissance, et donc de faire baisser la résistance du corps photoconducteur à l'état passant. Le rapport entre la résistivité du corps photoconducteur à l'état passant et sa résistivité à l'état bloqué est donc amélioré.

Selon un mode de réalisation, la section transversale a une première dimension prise selon une première direction, par exemple sa largeur, et une deuxième dimension prise selon une deuxième direction orthogonale à la première direction, par exemple sa hauteur, et la première dimension de la section transversale du corps photoconducteur diminue progressivement, la deuxième dimension restant constante.

En d'autres termes, il est possible de ne faire varier que la largeur du corps photoconducteur, sa hauteur restant constante.

Comme indiqué ci-dessus, la première dimension peut être la largeur de la section transversale, comptée parallèlement à une face supérieure du substrat et la deuxième dimension peut être la hauteur de la section transversale comptée perpendiculairement à la face supérieure du substrat.

La première dimension du corps photoconducteur peut décroître par paliers selon une enveloppe décroissant linéairement avec la distance par rapport à la première extrémité selon la direction longitudinale.

La décroissance par paliers permet avantageusement de réaliser le dispositif par des procédés classiques de fabrication CMOS.

La première dimension du corps photoconducteur peut décroître par paliers selon une enveloppe décroissant de façon exponentielle avec la distance par rapport à la première extrémité selon la direction longitudinale.

Les inventeurs ont par ailleurs observé que le nombre de photons absorbés le long du photoconducteur décroît de façon exponentielle. Un corps photoconducteur dont la largeur décroît exponentiellement permet d'adapter la forme du corps photoconducteur au nombre de photons absorbés à un endroit donné du corps photoconducteur, et donc d'améliorer l'homogénéité de la résistivité à l'état passant le long du corps photoconducteur. Le rapport entre la résistivité à l'état passant sur la résistivité à l'état bloqué est ainsi encore amélioré.

Selon un mode de réalisation, la première dimension de l'enveloppe du corps photoconducteur décroît de façon exponentielle avec le produit du coefficient d'absorption du corps photoconducteur par la distance par rapport à la première extrémité selon la direction longitudinale.

Le coefficient d'absorption d'un matériau est le rapport entre le nombre de photons absorbés par ce matériau lorsqu'il est éclairé sur le nombre de photons non absorbés, ou photons incidents. Ce rapport varie d'un matériau à un autre.

Ainsi, la forme du corps photoconducteur est encore d'avantage adaptée au taux d'absorption des photons, qui dépend du coefficient d'absorption du matériau du corps photoconducteur.

Le corps photoconducteur peut comporter une pluralité de portions juxtaposées disposées selon la direction longitudinale entre la première extrémité et la deuxième extrémité, les portions étant configurées de sorte que les premières dimensions de leur section transversale respective comptées dans la première direction décroissent selon lesdits paliers.

Le signal optique peut être délivré au niveau de la première extrémité et est destiné à se propager selon la direction longitudinale.

Selon un mode de réalisation, le substrat est un substrat de type silicium sur isolant qui comporte un film semi-conducteur réalisé sur une couche isolante enterrée, elle-même réalisée sur un substrat porteur, et la première direction est parallèle à la couche isolante enterrée et la deuxième direction est orthogonale à la couche isolante enterrée, et le corps photoconducteur est réalisé dans le film semi-conducteur.

Selon un autre aspect, il est proposé un circuit électronique intégré comportant au moins un commutateur optique tel que décrit précédemment.

Le circuit électronique intégré peut être un échantillonneur-bloqueur.

D'autres avantages et caractéristiques de l'invention apparaîtront à l'examen de la description détaillée de modes de réalisation de l'invention, nullement limitatifs, et des dessins annexés sur lesquels :

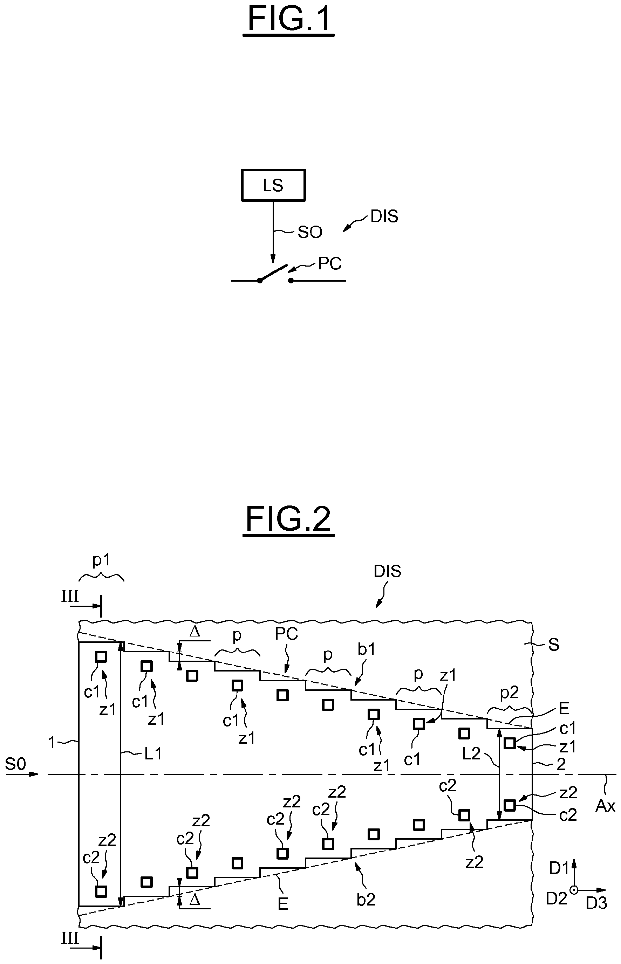

- les figures 1 à 6 illustrent des modes de réalisation de l'invention.

La figure 1 illustre de façon schématique un commutateur optique DIS selon un mode de réalisation.

Le commutateur optique DIS est couplé à un générateur LS de signal impulsionnel optique SO, par exemple ici un laser, configuré pour délivrer le signal optique impulsionnel SO au commutateur DIS, comportant ici un corps photoconducteur PC.

Le signal optique impulsionnel SO peut prendre ici deux valeurs, dont une première valeur, par exemple une valeur non nulle correspondant à la génération d'une impulsion lumineuse, ici une impulsion lumineuse d'une longueur d'onde de mille cinq cent cinquante nanomètres, et une deuxième valeur, par exemple une valeur nulle correspondant à l'absence d'impulsion lumineuse.

Le dispositif présenté ici est compatible avec une plage de longueurs d'onde du signal optique allant de mille deux cents nanomètres à mille six cents nanomètres, cette plage de valeurs dépendant du matériau utilisé pour la réalisation du corps photoconducteur PC.

Le commutateur DIS est configuré pour être soit dans un état électriquement passant, activé par la présence d'une impulsion lumineuse, soit dans un état électriquement bloqué, activé par l'absence d'impulsion lumineuse.

En d'autres termes, le commutateur DIS est configuré pour commuter au rythme des impulsions du signal optique impulsionnel SO.

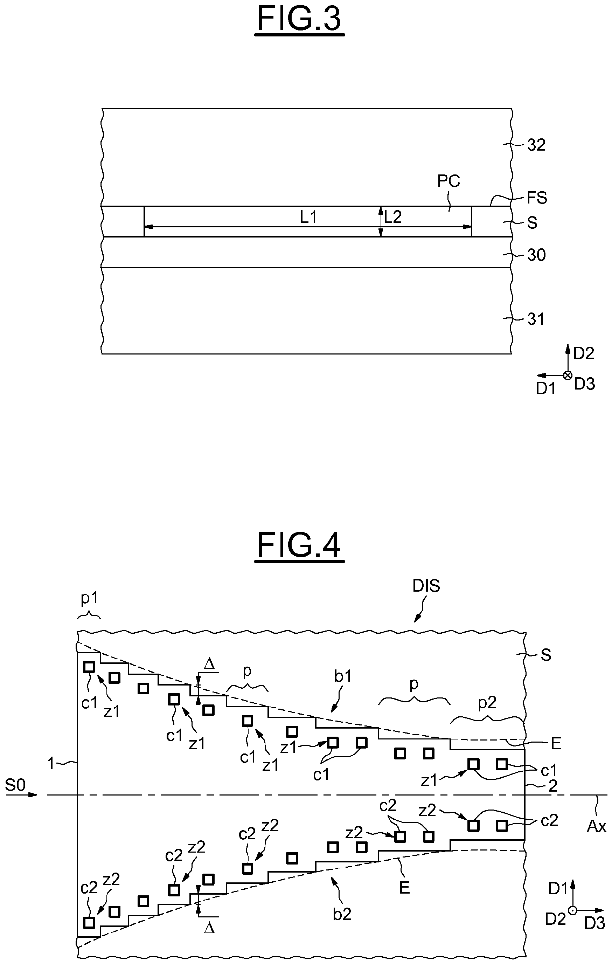

Comme l'illustrent la figure 2 et la figure 3 qui est une section transversale de la figure 2 selon la ligne de coupe III-III, le corps photoconducteur PC est réalisé dans un substrat semi-conducteur S, par exemple ici du silicium, et comprend un matériau photoconducteur, par exemple ici du germanium.

Il serait également possible que le corps photoconducteur soit réalisé avec un autre matériau, par exemple du silicium. Dans ce cas, la longueur d'onde du signal optique SO devrait être comprise entre six cents nanomètres et mille nanomètres.

Par exemple ici, le commutateur DIS est réalisé au sein d'un circuit photonique intégré, et le substrat semi-conducteur S est un film semi-conducteur réalisé au dessus d'une couche isolante enterrée 30 (« BOX » selon une dénomination anglo-saxonne habituellement utilisée), par exemple de l'oxyde de silicium, elle-même réalisée sur un substrat porteur 31. L'ensemble film semi-conducteur S - couche isolante enterrée 30 - substrat porteur 31 forme un substrat de type silicium sur isolant (SOI : Silicon On Insulator). Le substrat S est classiquement surmonté par une partie d'interconnexion 32 comportant différents niveaux de métal et des vias permettant de connecter les composants du circuit.

La section transversale du corps photoconducteur PC a ici une première dimension, ou largeur, prise selon une première direction D1, une deuxième dimension, ou hauteur, prise selon une deuxième dimension D2 orthogonale à la première direction D1. Le corps photoconducteur a une troisième dimension, ou longueur, prise selon une direction longitudinale D3 allant d'une première extrémité 1 du corps photoconducteur PC à une deuxième extrémité 2 du corps photoconducteur PC.

Le corps photoconducteur PC a ici une longueur de trente micromètres, la première extrémité 1 a une largeur initiale L1, par exemple ici quinze micromètres, et la deuxième extrémité 2 a une largeur finale L2, par exemple ici quatre micromètres.

En effet, la section transversale du corps photoconducteur PC diminue progressivement selon la direction longitudinale D3, depuis la première extrémité 1 vers la deuxième extrémité 2. Dans cet exemple, seule la largeur de la section transversale du corps photoconducteur diminue, la hauteur de la section transversale restant constante. Par « progressivement » on entend que la largeur de la section transversale du corps photoconducteur diminue selon une enveloppe dont la largeur décroît de façon régulière entre la première extrémité 1 et la deuxième extrémité 2, comme il sera vu ci-après.

Plus précisément, le corps photoconducteur PC comprend ici une pluralité de portions p juxtaposées, qui ont chacune une largeur constante mais inférieure à la largeur de la portion qui la précède (en partant de l'extrémité 1). A des fins de clarté des figures, seules certaines portions p sont référencées.

Le corps photoconducteur PC n'a donc pas des bords b1 et b2 continus, ce qui permet avantageusement de pouvoir réaliser le corps photoconducteur PC par des procédés classiques de fabrication.

Chacun des bords b1 et b2 du corps photoconducteur PC est donc en forme d'escalier, et décroît par palier avec un pas Δ de 0,6 micromètre.

Puisque le pas Δ entre chaque palier et la longueur de chaque portion p sont constants, la largeur de l'enveloppe E du corps photoconducteur PC décroit de façon linéaire.

Ainsi, chaque portion p a une différence de largeur de 1,2 micromètre avec chacune des portions qui la jouxte, et toutes les portions sont centrées autour d'un axe de symétrie Ax colinéaire à la direction longitudinale D3.

Chaque portion p prise individuellement a classiquement une résistivité proportionnelle à ses dimensions, la résistivité du corps photoconducteur PC diminue donc en s'éloignant de la première extrémité 1 selon la direction longitudinale D3.

Une première série de zones de contact électrique z1 est réalisée le long du premier bord b1 du corps photoconducteur PC, et une deuxième série de zones de contact électrique z2 est réalisée le long du deuxième bord b2 du corps photoconducteur.

Les zones de contacts électriques des séries z1 et z2 sont réalisées de façon classique par dopage et siliciuration d'une partie du corps photoconducteur PC et sont chacune configurées pour recevoir respectivement une première série de contacts c1 et une deuxième série de contacts électriques c2, par exemple des piliers de tungstène couplés à des pistes métalliques de la partie d'interconnexion du circuit intégré CI.

La première série de contacts électriques c1 forme une entrée du commutateur DIS, et est configurée pour recevoir un signal électrique radiofréquence, ou signal électrique d'entrée. La deuxième série de contacts électriques c2 forme une sortie du commutateur DIS, et est configurée pour délivrer le signal électrique radiofréquence, ou signal électrique de sortie.

Le générateur LS de signal optique impulsionnel SO, non représenté sur les figures 2 et 3 à des fins de simplification, est configuré pour délivrer le signal optique impulsionnel SO au niveau de la première extrémité 1, selon la direction longitudinale D3.

Lors d'une impulsion du signal optique impulsionnel SO, c'est-à-dire lorsque le corps photoconducteur PC est éclairé, la résistivité du corps photoconducteur PC diminue de façon proportionnelle au nombre de photons absorbés. Ainsi, à la réception d'une impulsion du signal optique SO, le corps photoconducteur passe dans l'état électriquement conducteur et le signal radiofréquence peut circuler entre la première série de contacts c1 et la deuxième série de contacts c2.

Le nombre de photons absorbés diminuant le long du corps photoconducteur PC, la baisse de résistivité sera maximale sur la première portion p1, et minimale sur la dernière portion p2.

Cela étant, puisque les dimensions des portions p, ici la largeur, et donc leur résistivité diminuent le long du corps photoconducteur PC, l'impact sur la résistivité d'une plus faible absorption de photons par une portion p sera en partie compensé par une diminution de ses dimensions.

Lors de la réception d'une impulsion du signal optique SO, on a donc une résistivité le long du corps photoconducteur PC plus homogène que pour un corps photoconducteur ayant une largeur constante, et également un rapport plus élevé de la résistivité du commutateur DIS à l'état bloqué sur sa résistivité à l'état passant, et donc un commutateur plus performant.

La diminution linéaire de l'enveloppe E constitue une approximation acceptable de la diminution de l'absorption des photons. Cela étant, l'absorption des photons diminue de façon exponentielle avec la distance selon la direction longitudinale D3 par rapport à la première extrémité 1, et dépend notamment du coefficient d'absorption du matériau du corps photoconducteur PC.

Ainsi, comme l'illustre la figure 4, le commutateur peut avantageusement comprendre un corps photoconducteur PC dont la largeur décroît par palier selon une enveloppe E dont la largeur décroît de façon exponentielle en fonction de la distance selon la direction longitudinale D3 par rapport à la première extrémité 1 et en fonction du coefficient d'absorption $\alpha$ du matériau du corps photoconducteur PC, ici du germanium.

La largeur de chaque portion p du corps photoconducteur est ici définie selon l'équation (I)

$$L = L1 * e^{-\alpha x} \qquad (I)$$

avec L la largeur de la portion considérée, L1 la largeur de la section transversale au niveau de la première extrémité 1, x la distance de la portion considérée par rapport à la première extrémité 1, et $\alpha$ le coefficient d'absorption du corps photoconducteur PC.

En fonction du matériau utilisé, et de la technologie de fabrication du circuit intégré CI, il existe un seuil minimal réalisable par gravure pour le pas Δ entre deux portions p successives.

Par exemple ici, le seuil minimum pour le pas Δ est de 0,6 micromètre.

Ainsi, il est avantageux de garder un pas Δ fixe entre chaque portion p du corps photoconducteur, et de faire varier la longueur de chaque portion p afin de respecter la géométrie imposée par l'équation (I).

Les longueurs des portions augmentent donc avec la distance selon la deuxième direction D2 par rapport à la première extrémité 1.

Ainsi, les dimensions de chaque portion p sont particulièrement adaptées au nombre de photons qu'elle est susceptible d'absorber, l'homogénéité de la résistivité le long du corps photoconducteur PC est donc améliorée encore davantage.

Le corps photoconducteur PC a également un rapport de sa résistivité à l'état bloqué sur sa résistivité à l'état passant qui est encore plus élevé, et le commutateur DIS est donc encore plus efficace.

A titre indicatif, pour une source optique LS délivrant un signal optique SO d'une longueur d'onde de mille cinq cent cinquante nanomètres, et pour un corps photoconducteur PC d'une longueur de trente micromètres, ce rapport pour un commutateur tel que décrit en lien avec la figure 4 est deux fois supérieur au même rapport pour un commutateur ayant une section transversale de dimension constante.

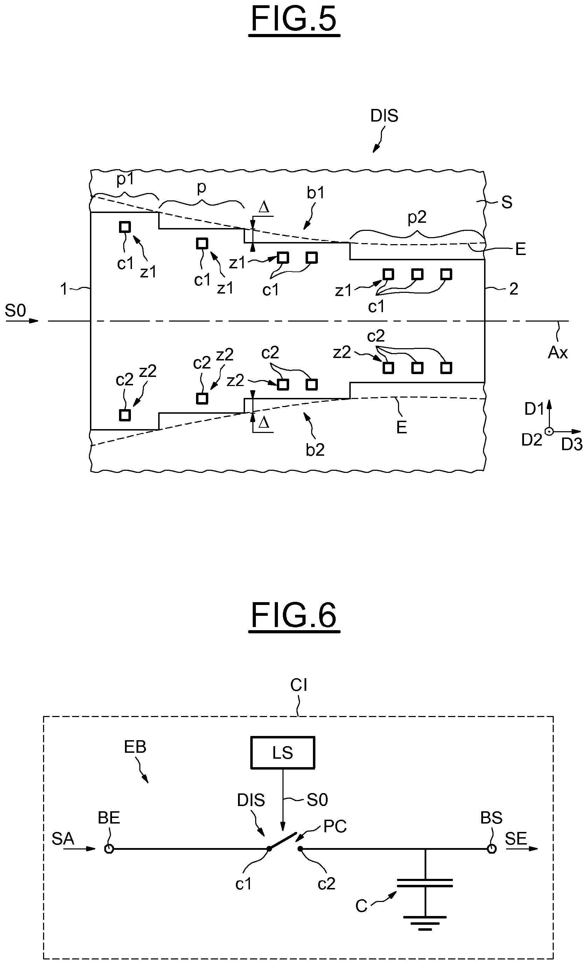

En fonction de la largeur L1 au niveau de la première extrémité 1, de la largeur L2 au niveau de la deuxième extrémité 2, et/ou de la longueur du corps photoconducteur PC, il est possible, comme l'illustre la figure 5, d'obtenir un commutateur ayant un nombre de portions différent, ayant des longueurs différentes avec un pas Δ différent supérieur au seuil minimal.

La figure 6 illustre de façon schématique et d'un point de vue électrique un circuit électronique intégré CI, comportant ici un échantillonneur-bloqueur EB comportant un commutateur DIS selon un mode de réalisation de l'invention.

L'échantillonneur-bloqueur EB comporte une borne d'entrée BE, couplée à la première série de contacts c1 du commutateur, et est classiquement configuré pour recevoir un signal électronique analogique SA, par exemple un signal radiofréquence, et une borne de sortie BS couplée à la deuxième série de contacts c2 du commutateur DIS, et configurée pour délivrer un signal échantillonné SE.

Un condensateur C est couplé entre la deuxième série de contacts c2 et la masse.

L'échantillonnage est donc ici réalisé au rythme des impulsions du signal optique impulsionnel LS. L'utilisation du commutateur DIS permet ici de réduire les erreurs d'échantillonnage dues aux phénomènes de gigue et d'avoir des commutations plus efficaces.

Bien qu'il ait été décrit précédemment en lien avec les figures 1 à 5 un corps photoconducteur PC réalisé sur un substrat en silicium et comportant du germanium, il serait possible d'utiliser d'autres matériaux photoconducteurs compatibles avec les procédés de fabrication classiques. L'homme du métier saura choisir les matériaux adaptés en fonction des applications envisagées.

Il en est de même pour la longueur d'onde du signal optique impulsionnel SO qui peut être choisie à une valeur différente de celle présentée en lien avec les modes de réalisation décrits précédemment.

Et, bien qu'il ait été décrit en lien avec la figure 6 un commutateur DIS compris dans un échantillonneur-bloqueur EB, le commutateur DIS est compatible avec tout type de circuit intégré mettant en œuvre des opérations de commutation.

Bien que, pour faire varier la section transversale du corps photoconducteur PC, il soit plus simple technologiquement de faire varier uniquement la première dimension, par exemple la largeur, de cette section transversale comme décrit précédemment, il serait également envisageable de faire varier la deuxième dimension, par exemple la hauteur, ou encore de faire varier à la fois la première dimension et la deuxième dimension.

## Revendications

1. Commutateur optique intégré réalisé dans et sur un substrat semi-conducteur, comportant un corps photoconducteur (PC) comprenant une première extrémité (1) configurée pour recevoir un signal électrique d'entrée et une deuxième extrémité (2) configurée pour délivrer un signal électrique de sortie, le corps photoconducteur (PC) étant configuré pour avoir un état électriquement passant activé par la présence d'un signal optique (SO) et un état électriquement bloqué activé par l'absence du signal optique (SO), dans lequel la direction allant de la première extrémité vers la deuxième extrémité définit une direction longitudinale (D3), **caractérisé en ce que** le corps photoconducteur a une section transversale orthogonale à la direction longitudinale (D3) diminuant selon la direction longitudinale (D3) depuis la première extrémité (1) vers la deuxième extrémité (2).

2. Commutateur selon la revendication 1, dans lequel la section transversale du corps photoconducteur (PC) diminue selon une enveloppe (E) qui décroît de façon progressive.

3. Commutateur selon la revendication 1 ou 2, dans lequel la section transversale a une première dimension prise selon une première direction (D1), une deuxième dimension prise selon une deuxième direction (D2) orthogonale à la première direction (D1), et la première dimension de la section transversale du corps photoconducteur (PC) diminue progressivement, la deuxième dimension restant constante (D1).

**4.** Commutateur selon l'une quelconque des revendications 1 à 3, dans lequel la première dimension est la largeur de la section transversale, comptée parallèlement à une face supérieure du substrat et la deuxième dimension (D2) est la hauteur de la section transversale comptée perpendiculairement à la face supérieure du substrat.

**5.** Commutateur selon l'une quelconque des revendications 2 à 4, dans lequel la première dimension du corps photoconducteur (PC) décroît par paliers selon l'enveloppe (E) qui décroît linéairement avec la distance par rapport à la première extrémité (1) selon la direction longitudinale (D3).

**6.** Commutateur selon l'une quelconque des revendications 2 à 4, dans lequel la première dimension du corps photoconducteur (PC) décroît par paliers selon l'enveloppe (E) qui décroit de façon exponentielle avec la distance par rapport à la première extrémité (1) selon la direction longitudinale (D3).

**7.** Commutateur selon la revendication 6, dans lequel la première dimension de l'enveloppe (E) du corps photoconducteur (PC) décroît de façon exponentielle avec le produit du coefficient d'absorption ($\alpha$) du corps photoconducteur (PC) par la distance par rapport à la première extrémité (1) selon la direction longitudinale (D3).

**8.** Commutateur selon la revendication 5 ou 6 dans lequel le corps photoconducteur (PC) comporte une pluralité de portions (p) juxtaposées disposées selon la direction longitudinale (D3) entre la première extrémité (1) et la deuxième extrémité (2), les portions (p) étant configurées de sorte que les premières dimensions de leur section transversale respective comptées dans la première direction (D1) décroissent selon lesdits paliers.

**9.** Commutateur selon l'une quelconque des revendications 1 à 8, dans lequel le signal optique est délivré au niveau de la première extrémité (1) et est destiné à se propager selon la direction longitudinale (D3).

**10.** Commutateur selon l'une quelconque des revendications 1 à 9, dans lequel le substrat (S) est un substrat de type silicium sur isolant qui comporte un film semi-conducteur réalisé sur une couche isolante enterrée (30), elle-même réalisée sur un substrat porteur (31), la première direction (D1) est parallèle à la couche isolante enterrée (30) et la deuxième direction (D2) est orthogonale à la couche isolante enterrée, et le corps photoconducteur (PC) est réalisé dans le film semi-conducteur.

**11.** Circuit électronique intégré comportant au moins un commutateur optique (DIS) selon l'une quelconque des revendications précédentes.

**12.** Circuit selon la revendication 11, étant un échantillonneur-bloqueur (EB).

**Patentansprüche**

**1.** Integrierter optischer Schalter, der in und auf einem Halbleitersubstrat ausgeführt ist, umfassend einen photoleitenden Körper (PC), umfassend ein erstes Ende (1), das ausgestaltet ist, ein elektrisches Eingangssignal zu empfangen, und ein zweites Ende (2), das ausgestaltet ist, ein elektrisches Ausgangssignal auszugeben, wobei der photoleitende Körper (PC) ausgestaltet ist, einen elektrisch leitenden Zustand aufzuweisen, der durch das Vorhandensein eines optischen Signals (SO) aktiviert wird, und einen elektrisch gesperrten Zustand, der durch die Abwesenheit des optischen Signals (SO) aktiviert wird, wobei die Richtung, die von dem ersten Ende zu dem zweiten Ende geht, eine Längsrichtung (D3) definiert, **dadurch gekennzeichnet, dass** der photoleitende Körper einen Querschnitt orthogonal zu der Längsrichtung (D3) aufweist, der gemäß der Längsrichtung (D3) ausgehend von dem ersten Ende (1) zu dem zweiten Ende (2) abnimmt.

**2.** Schalter nach Anspruch 1, wobei der Querschnitt des photoleitenden Körpers (PC) gemäß einer Hülle (E) abnimmt, die sich progressiv verringert.

**3.** Schalter nach Anspruch 1 oder 2, wobei der Querschnitt eine erste Dimension aufweist, die gemäß einer ersten Richtung (D1) genommen wird, eine zweite Dimension, die gemäß einer zweiten Richtung (D2) orthogonal zu der ersten Richtung (D1) genommen wird, und die erste Dimension des Querschnitts des photoleitenden Körpers (PC) progressiv abnimmt, wobei die zweite Dimension konstant bleibt (D1).

**4.** Schalter nach einem der Ansprüche 1 bis 3, wobei die erste Dimension die Breite des Querschnitts ist, die parallel zu einer oberen Fläche des Substrats gezählt wird, und die zweite Dimension (D2) die Höhe des Querschnitts ist, die senkrecht zu der oberen Fläche des Substrats gezählt wird.

**5.** Schalter nach einem der Ansprüche 2 bis 4, wobei sich die erste Dimension des photoleitenden Körpers (PC) schrittweise gemäß der Hülle (E) verringert, die sich linear mit der Distanz in Bezug auf das erste Ende (1) gemäß der Längsrichtung (D3) verringert.

**6.** Schalter nach einem der Ansprüche 2 bis 4, wobei sich die erste Dimension des photoleitenden Körpers (PC) schrittweise gemäß der Hülle (E) verringert, die sich exponentiell mit der Distanz in Bezug auf das erste Ende (1) gemäß der Längsrichtung (D3) verringert.

7. Schalter nach Anspruch 6, wobei sich die erste Dimension der Hülle (E) des photoleitenden Körpers (PC) exponentiell mit dem Produkt des Absorptionskoeffizienten ($\alpha$) des photoleitenden Körpers (PC) mal der Distanz in Bezug auf das erste Ende (1) gemäß der Längsrichtung (D3) verringert.

8. Schalter nach Anspruch 5 oder 6, wobei der photoleitende Körper (PC) eine Vielzahl von nebeneinanderliegenden Abschnitten (p) umfasst, die gemäß der Längsrichtung (D3) zwischen dem ersten Ende (1) und dem zweiten Ende (2) angeordnet sind, wobei die Abschnitte (p) so ausgestaltet sind, dass sich die ersten Dimensionen ihres jeweiligen Querschnitts, die in der ersten Richtung (D1) gezählt werden, gemäß den Schritten verringern.

9. Schalter nach einem der Ansprüche 1 bis 8, wobei das optische Signal auf Höhe des ersten Endes (1) ausgegeben wird und dazu bestimmt ist, sich gemäß der Längsrichtung (D3) auszubreiten.

10. Schalter nach einem der Ansprüche 1 bis 9, wobei das Substrat (S) ein Substrat vom Typ Silizium auf Isolator ist, das einen Halbleiterfilm umfasst, der auf einer eingebetteten Isolierschicht (30) ausgeführt ist, die ihrerseits auf einem Trägersubstrat (31) ausgeführt ist, die erste Richtung (D1) parallel zu der eingebetteten Isolierschicht (30) verläuft und die zweite Richtung (D2) orthogonal zu der eingebetteten Isolierschicht verläuft und der photoleitende Körper (PC) in dem Halbleiterfilm ausgeführt ist.

11. Integrierte elektronische Schaltung, umfassend wenigstens einen optischen Schalter (DIS) nach einem der vorstehenden Ansprüche.

12. Schaltung nach Anspruch 11, wobei sie eine Abtasthalteschaltung (EB) ist.

**Claims**

1. Integrated optical switch made in and on a semiconductor substrate, including a photoconductive body (PC) comprising a first end (1) configured to receive an input electrical signal and a second end (2) configured to deliver an output electrical signal, the photoconductive body (PC) being configured to have an electrically conductive state activated by the presence of an optical signal (SO) and an electrically blocked state activated by the absence of the optical signal (SO), wherein the direction from the first end to the second end defines a longitudinal direction (D3), **characterised in that** the photoconductive body has a cross section orthogonal to the longitudinal direction (D3) decreasing in the longitudinal direction (D3) from the first end (1) to the second end (2) .

2. Switch according to claim 1, wherein the cross section of the photoconductive body (PC) decreases along an envelope (E) which is gradually decreasing.

3. Switch according to claim 1 or 2, wherein the cross section has a first dimension taken in a first direction (D1), a second dimension taken in a second direction (D2) orthogonal to the first direction (D1), and the first dimension of the cross section of the photoconductive body (PC) progressively decreases, the second dimension remaining constant (D1).

4. Switch according to any one of claims 1 to 3, wherein the first dimension is the width of the cross section, counted parallel to an upper face of the substrate and the second dimension (D2) is the height of the cross section counted perpendicular to the upper face of the substrate.

5. Switch according to any one of claims 2 to 4, wherein the first dimension of the photoconductive body (PC) decreases in steps according to the envelope (E) which decreases linearly with the distance relative to the first end (1) in the longitudinal direction (D3).

6. Switch according to any one of claims 2 to 4, wherein the first dimension of the photoconductive body (PC) decreases in steps according to the envelope (E) which decreases exponentially with the distance relative to the first end (1) in the longitudinal direction (D3).

7. Switch according to claim 6, wherein the first dimension of the envelope (E) of the photoconductive body (PC) decreases exponentially with the product of the absorption coefficient ($\alpha$) of the photoconductive body (PC) by the distance relative to the first end (1) in the longitudinal direction (D3) .

8. Switch according to claim 5 or 6, wherein the photoconductive body (PC) includes a plurality of juxtaposed portions (p) disposed in the longitudinal direction (D3) between the first end (1) and the second end (2), the portions (p) being configured such that the first dimensions of the respective cross section thereof which are counted in the first direction (D1) decrease according to said steps.

9. Switch according to any one of claims 1 to 8, wherein the optical signal is delivered at the first end (1) and is intended to be propagated in the longitudinal direction (D3) .

10. Switch according to any one of claims 1 to 9, wherein the substrate (S) is a silicon-on-insulator type substrate which includes a semiconductor film made on a buried insulating layer (30), itself made on a carrier substrate (31), the first direction (D1) is parallel to the buried insulating layer (30) and the second direction (D2) is orthogonal to the buried insulating layer, and the photoconductive body (PC) is made in the semiconductor film.

11. Integrated electronic circuit including at least one optical switch (DIS) according to any one of the preceding claims.

12. Circuit according to claim 11, being a sample and hold circuit (EB).

# FIG.1

# FIG.2

## FIG.3

## FIG.4

# FIG.5

DIS

p1  p  b1

$\Delta$

p2

S

E

c1  z1
c1  z1
z1
c1
z1
c1

1

2

S0

Ax

c2  z2
c2  z2
z2  c2
c2
z2

c2

E

b2

D1
D2  D3

# FIG.6

CI

EB

LS

DIS  S0

BE

SA

PC

BS  SE

c1  c2

C

**EP 3 676 960 B1**

## RÉFÉRENCES CITÉES DANS LA DESCRIPTION

**Documents brevets cités dans la description**

- US 2015349182 A